**Europäisches Patentamt**

**European Patent Office**

**Office européen des brevets**

(19)

(11) Veröffentlichungsnummer: **0 106 195**

**A2**

(12) # EUROPÄISCHE PATENTANMELDUNG

(21) Anmeldenummer: **83109307.5**

(22) Anmeldetag: **20.09.83**

(51) Int. Cl.³: **H 01 L 27/06**

(30) Priorität: **20.10.82 DE 3238748**

(43) Veröffentlichungstag der Anmeldung:
**25.04.84 Patentblatt 84/17**

(84) Benannte Vertragsstaaten:
**DE FR GB IT NL SE**

(71) Anmelder: **ROBERT BOSCH GMBH**
**Postfach 50**
**D-7000 Stuttgart 1(DE)**

(72) Erfinder: **Gademann, Lothar, Dipl.-Ing.**
**Sülchenstrasse 42**
**D-7407 Rottenburg(DE)**

(72) Erfinder: **Michel, Hartmut, Dipl.-Ing.**
**Aaranstrasse 56**
**D-7410 Reutlingen(DE)**

(54) **Monolithisch integrierte Schaltungsanordnung.**

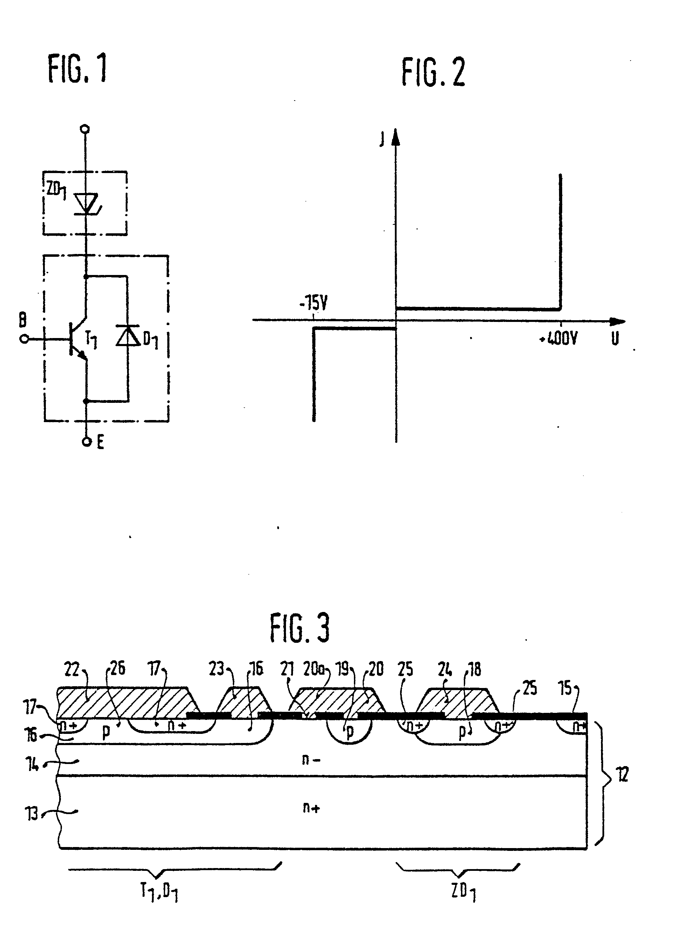

(57) Es wird eine in einem Halbleiterplättchen (12) untergebrachte monolithisch integrierte Schaltungsanordnung mit einem npn-Transistor $(T_1)$ und mit einer Zenerdiode $(ZD_1)$ vorgeschlagen. Die Zenerdiode $(ZD_1)$ ist mit ihrer Kathode an den Kollektor des Transistors $(T_1)$ angeschlossen. Die Kollektorzone des Transistors $(T_1)$ wird dabei durch eine $n^-$-leitende Zone (14), die Basiszone des Transistors $(T_1)$ durch eine in die Kollektorzone (14) eindiffundierte erste p-leitende Zone (16) und die Emitterzone des Transistors $(T_1)$ durch eine in die Basiszone (16) eindiffundierte $n^+$-leitende Zone (17) gebildet. Die Kathode der Zenerdiode $(ZD_1)$ wird durch die $n^-$-leitende Kollektorzone (14) des Transistors $(T_1)$ und die Anode der Zenerdiode $(ZD_1)$ durch eine zweite, in die Kollektorzone (14) eindiffundierte p-leitende Zone (18) gebildet. Ferner ist eine mit ihrer Anode an den Emitter und mit ihrer Kathode an den Kollektor des Transistors $(T_1)$ angeschlossene Diode $(D_1)$ vorgesehen, die dadurch eingeführt ist, daß die Emitterzone (17) des Transistors $(T_1)$ im Bereich unterhalb der Emittermetallisierung (22) eine mit Basismaterial ausgefüllte Aussparung (26) aufweist, innerhalb der die Basiszone (16) des Transistors $(T_1)$ bis zur Emittermetallisierung (22) dieses Transistors reicht (Figur 3).

FIG. 3

R. 18137

14.10.1982 Fb/Kc

ROBERT BOSCH GMBH, 7000 Stuttgart 1


## Monolithisch integrierte Schaltungsanordnung

Stand der Technik

Die Erfindung betrifft eine monolithisch integrierte
Schaltungsanordnung nach der Gattung des Hauptanspruchs.
Aus den vorveröffentlichten Unterlagen der europäischen
Patentanmeldung OO 11 964 ist bereits eine Schaltungsanordnung dieser Art bekannt, bei der der Transistor
im Vorwärtsbetrieb bis zu einer bestimmten Durchbruchsspannung sperrt, bei der jedoch keine Mittel zur Begrenzung der Spannung an der Emitter-Kollektor-Strecke
des Transistors im Rückwärtsbetrieb vorgesehen sind.


Vorteile der Erfindung

Die erfindungsgemäße monolithisch integrierte Schaltungsanordnung mit den kennzeichnenden Merkmalen des Hauptanspruchs hat demgegenüber den Vorteil, daß durch die Einführung der zweiten, einen Teil der Basis-Kollektor-Diode
des Transistors bildenden Diode und durch die Ausbildung

...

- 2 -

der ersten Diode als Zenerdiode die Spannung im Rückwärtsbetrieb bei einem bestimmten, voreinstellbaren Wert begrenzt wird. Im Anspruch 2 ist angegeben, wie die Zenerdiode in besonders vorteilhafter Weise ausgebildet werden kann. Weitere Vorteile ergeben sich aus den weiteren
Unteransprüchen 3 bis 5.

Zeichnung

Anhand der Zeichnung wird die Erfindung näher erläutert.
Es zeigen: Figur 1 das elektrische Schaltbild der erfindungsgemäßen monolithisch integrierten Schaltungsanordnung,
Figur 2 das Sperrkennfeld der Schaltungsanordnung nach Figur 1 und Figur 3 einen Schnitt durch ein vorteilhaftes
Layout.

Beschreibung des Ausführungsbeispiéls

Das in Figur 1 dargestellte Schaltbild der erfindungsgemäßen monolithisch integrierten Schaltungsanordnung zeigt
einen npn-Transistor $T_1$, eine mit ihrer Kathode an den
Kollektor des Transistors $T_1$ angeschlossene Zenerdiode
$ZD_1$ und eine Schutzdiode $D_1$, die mit ihrer Anode an den
Emitter und mit ihrer Kathode an den Kollektor des Transistors $T_1$ angeschlossen ist.

In Figur 2 ist das Sperrkennfeld der Schaltungsanordnung
nach Figur 1 dargestellt. Man erkennt, daß die Durchbruchsspannung des Transistors $T_1$ im Vorwärtsbetrieb bei
etwa 400 V erreicht wird, daß dagegen die Spannung im
Rückwärtsbetrieb, bedingt durch die Durchbruchsspannung
der Zenerdiode $ZD_1$ und durch die Flußspannung der Schutzdiode $D_1$, auf einen Wert von etwa -15 V begrenzt wird.

...

Figur 3 zeigt die Realisierung der Schaltungsanordnung nach Figur 1 in monolithisch integrierter Technik. Ein Halbleiterplättchen 12 besteht aus einem $n^+$-leitenden Substrat 13 und aus einer $n^-$-leitenden Epitaxialschicht 14. Die Epitaxialschicht 14 ist an ihrer freien Oberfläche mit einer Passivierungsschicht 15 aus Siliziumdioxid bedeckt, in die an verschiedenen Stellen Fenster für die Anbringung von Kontakten eingebracht sind. Die Kollektorzone des Transistors $T_1$ ist durch die $n^-$-leitende Epitaxialschicht 14 gebildet. Die Basiszone des Transistors $T_1$ ist durch eine in die Kollektorzone 14 eindiffundierte erste p-leitende Zone 16 gebildet, während die Emitterzone des Transistors $T_1$ durch eine in die Basiszone 16 eindiffundierte $n^+$-leitende Zone 17 gebildet ist.

Ferner ist eine als Zenerdiode ausgebildete erste Diode $ZD_1$ vorgesehen. Die Kathode dieser Zenerdiode $ZD_1$ wird durch die $n^-$-leitende Kollektorzone 14 des Transistors $T_1$ gebildet, während die Anode der Zenerdiode $ZD_1$ durch eine zweite, in die Kollektorzone 14 eindiffundierte p-leitende Zone 18 gebildet wird. Bestandteil der Zenerdiode $ZD_1$ ist erfindungsgemäß ferner eine $n^+$-leitende Zone 25, die in den Randbereich zwischen der zweiten p-leitenden Zone 18 und der Kollektorzone 14 eindiffundiert ist und sich überdies in die Zone 18 hinein erstrecken kann.

Ferner wird eine zweite, als Schutzdiode ausgebildete Diode $D_1$ (vgl. Figur 1) erfindungsgemäß dadurch eingeführt, daß die Emitterzone 17 des Transistors $T_1$ im Bereich unterhalb der Ermittermetallisierung 22 dieses Transistors eine mit Basismaterial ausgefüllte Aussparung 26 aufweist, innerhalb der die Basiszone 16 des Transistors $T_1$ bis zur Emittermetallisierung 22 dieses Transistors

...

reicht. Die Aussparung 26 kann dabei entweder in einem
mittleren Bereich der Emitterzone 17 als Insel oder in
einem Randbereich der Emitterzone 17 als Halbinsel ausgebildet sein. In jedem Falle muß aber die Emittermetallisierung 22 über die Aussparung 26 mindestens teilweise hinweggeführt sein, so daß die Basiszone 16 des
Transistors $T_1$ innerhalb dieser Aussparung durch die
Emittermetallisierung 22 kontaktiert wird und auf diese
Weise ein partieller Anschluß der Basis-Kollektor-Diode
des Transistors $T_1$ durch dessen Emittermetallisierung
gebildet wird.

Zwischen der p-leitenden Zone 18 und der p-leitenden
Zone 16 ist in die Kollektorzone 14 eine dritte p-leitende Zone 19 eindiffundiert, die über eine Metallisierung
20 mit der Kollektorzone 14 des Transistors $T_1$ verbunden
ist. Die Zone 19 verhindert eine Rückwirkung der Zenerdiode $ZD_1$ auf die Basis 16 des Transistors $T_1$. Die Verbindung der Zone 19 mit der Kollektorzone 14 wird durch
einen Ausläufer oder eine Verbreiterung 20a der Metallisierung 20 bewirkt, indem dieser Ausläufer oder diese
Verbreiterung über ein in der Passivierungsschicht 15
angebrachtes Kontaktfenster 21 mit der Kollektorzone
14 kontaktiert ist.

Weitere Metallisierungen sind mit 23 und 24 bezeichnet.
Die Metallisierung 23 ist dabei die Basismetallisierung
des Transistors $T_1$, während die Metallisierung 24 die
Metallisierung der Anode der Zenerdiode $ZD_1$ ist.

Die p-leitenden Zonen 16, 18 und 19 werden gemeinsam in
die Epitaxialschicht 14 eindiffundiert.

...

Die Erfindung ist nicht auf das anhand der Zeichnung beschriebene Ausführungsbeispiel beschränkt. Insbesondere kann die Zone 19 die Zonen 18, 25 ringförmig umschließen. Die den Rand der Zenerdiode $ZD_1$ bildenden Bereiche 25 können den Bereich 18 zur besseren Leistungsverteilung im Durchbruch zusätzlich gitterartig durchziehen. Anstelle des einfachen Transistors $T_1$ kann eine zwei- oder mehrstufige Darlingtonschaltung verwendet werden. Darüber hinaus ist eine inverse Struktur möglich, bei der die n-leitfähigen Zonen durch p-leitfähige Zonen ersetzt sind und umgekehrt.

0106195

R. 18137

14.10.1982 Fb/Kc

ROBERT BOSCH GMBH, 7000 Stuttgart 1

Ansprüche

1. In einem Halbleiterplättchen untergebrachte monolithisch integrierte Schaltungsanordnung mit einem Transistor $(T_1)$ und mit einer Diode $(ZD_1)$, die in die Kollektorzuleitung des Transistors $(T_1)$ in Flußrichtung geschaltet ist, wobei die Kollektorzone des Transistors $(T_1)$ durch eine erste Zone (14) eines ersten Leitfähigkeitstyps in dem Halbleiterplättchen (12), die Basiszone des Transistors $(T_1)$ durch eine in die Kollektorzone (14) eindiffundierte erste Zone (16) eines zweiten, zur Kollektorzone (14) entgegengesetzten Leitfähigkeitstyps und die Emitterzone des Transistors $(T_1)$ durch eine in die Basiszone (16) eindiffundierte zweite Zone (17) vom ersten Leitfähigkeitstyp gebildet ist, wobei die an den Kollektor des Transistors $(T_1)$ angeschlossene Elektrode der Diode $(ZD_1)$ durch die Kollektorzone (14) des Transistors $(T_1)$ und die andere Elektrode der Diode $(ZD_1)$ durch eine zweite, in die Kollektorzone (14) eindiffundierte Zone (18) vom zweiten Leitfähigkeitstyp gebildet ist, dadurch gekennzeichnet, daß eine zweite, mit ihrer Anode an den

...

Emitter und mit ihrer Kathode an den Kollektor des
Transistors ($T_1$) angeschlossene Diode ($D_1$) dadurch eingeführt ist, daß die Emitterzone (17) des Transistors ($T_1$)
im Bereich unterhalb der Emittermetallisierung (22) eine
mit Basismaterial ausgefüllte Aussparung (26) aufweist,
innerhalb der die Basiszone (16) des Transistors ($T_1$)
bis zur Emittermetallisierung (22) dieses Transistors
reicht, und daß die erste Diode ($ZD_1$) als Zenerdiode ausgebildet ist.

2. Schaltungsanordnung nach Anspruch 1, dadurch gekennzeichnet, daß zur Ausbildung der ersten Diode ($ZD_1$) als
Zenerdiode eine dritte Zone (25) vom ersten Leitfähigkeitstyp vorgesehen ist, die gegenüber der Kollektorzone (14) eine erhöhte Störstellenkonzentration aufweist und in den Randbereich zwischen der zweiten Zone
(18) des zweiten Leitfähigkeitstyps und der Kollektorzone (14) eindiffundiert ist.

3. Schaltungsanordnung nach Anspruch 1 oder 2, dadurch
gekennzeichnet, daß zur Trennung des Transistors ($T_1$)
von der Zenerdiode ($ZD_1$) in die Kollektorzone (14) eine
dritte Zone (19) vom zweiten Leitfähigkeitstyp eindiffundiert ist, die durch den Zwischenraum zwischen der ersten
(16) und der zweiten (18) Zone vom zweiten Leitfähigkeitstyp hindurch verläuft und über eine Metallisierung (20)
mit der Kollektorzone (14) des Transistors ($T_1$) verbunden
ist.

4. Schaltungsanordnung nach den Ansprüchen 2 und 3, dadurch gekennzeichnet, daß die dritte Zone (19) des zweiten Leitfähigkeitstyps die zweite Zone (18) des zweiten
Leitfähigkeitstyps und die dritte Zone (25) des ersten
Leitfähigkeitstyps ringförmig umschließt.

...

- 3 -

5. Schaltungsanordung nach einem der Ansprüche 1 bis 4, dadurch gekennzeichnet, daß die erste (16), die zweite (18) und ggf. die dritte (19) Zone des zweiten Leitfähigkeitstyps dieselbe Diffusionstiefe, dasselbe Diffusionsprofil und dieselbe Oberflächenkonzentration haben und daß die zweite Zone (17) und die dritte Zone (25) des ersten Leitfähigkeitstyps ebenfalls dieselbe Diffusionstiefe, dasselbe Diffusionsprofil und dieselbe Oberflächenkonzentration haben.

# FIG. 1

# FIG. 2

# FIG. 3